# FASCICULE DE BREVET EUROPEEN

(11) **EP 2 771 911 B1**
(45) Date de publication et mention de la délivrance du brevet: **16.09.2015**
(21) Numéro de dépôt: 12775522.1
(22) Date de dépôt: 24.10.2012
(51) Int. Cl.: H01L 21/762

(54) **PROCEDE DE TRAITEMENT ET DE COLLAGE DIRECT D'UNE COUCHE DE MATERIAU**
VERFAHREN ZUR BEHANDLUNG UND DIREKTEN BINDUNG EINER MATERIALSCHICHT
METHOD FOR TREATING AND DIRECTLY BONDING A LAYER OF MATERIAL

(30) Priorité: 26.10.2011 FR 1159722
(43) Date de publication de la demande: 03.09.2014
(73) Titulaire: Commissariat à l'Énergie Atomique et aux Énergies Alternatives, 75015 Paris (FR)
(72) Inventeur: MORICEAU, Hubert, F-38120 Saint-Egreve (FR); FOURNEL, Franck, F-38190 Villard-Bonnot (FR); MORALES, Christophe, F-38220 St Pierre De Mesage (FR); RAUER, Caroline, F-38000 Grenoble (FR)
(74) Mandataire: Ahner, Philippe
(86) Numéro de dépôt international: PCT/EP2012/071067
(87) Numéro de publication internationale: WO 2013/060729

(56) Documents cités:
- EP-A1- 1 381 086
- FR-A1- 2 868 599
- FR-A1- 2 912 839
- US-A1- 2004 126 993

## Description

### DOMAINE TECHNIQUE

L'invention concerne le domaine du collage direct, et notamment un procédé de traitement permettant d'augmenter une énergie de surface d'au moins une couche de matériau, avantageusement composée d'oxyde de silicium, destinée à être solidarisée à une deuxième couche de matériau par la mise en oeuvre d'un collage direct entre ces deux couches.

L'invention concerne également un procédé de solidarisation par collage direct d'une première couche de matériau ayant subie un tel procédé de traitement avec une deuxième couche de matériau.

### ÉTAT DE LA TECHNIQUE ANTÉRIEURE

Le collage direct, également appelé collage moléculaire ou collage par adhérence moléculaire, consiste à solidariser deux surfaces de matériau l'une contre l'autre sans couche adhésive intermédiaire entre les deux surfaces. Dans ce type de collage, l'adhérence est obtenue grâce au fait que les surfaces à coller sont suffisamment lisses (typiquement avec une rugosité inférieure à environ 6 nm RMS), exemptes de particules ou de contaminations, et rapprochées l'une de l'autre telles que des forces attractives d'interaction électronique entre des atomes ou molécules des deux surfaces à coller se créent, par exemple des forces de Van der Waals, et ce à température et pression ambiantes. Des traitements thermiques peuvent être réalisés pendant ou après le collage pour augmenter l'énergie de collage entre les surfaces assemblées.

Un tel collage direct est utilisé dans de nombreuses applications pour coller notamment des couches d'oxyde obtenues par dépôt.

Ainsi, lorsque deux éléments, par exemple des substrats composés de semi-conducteur, à solidariser présentent des topologies en surface, il est possible de déposer une couche d'oxyde sur ces topologies, puis de procéder à une planarisation de ces oxydes déposés. De cette façon, on peut obtenir des surfaces planes, dont la topologie a été lissée, aptes à être collées par collage direct l'une contre l'autre.

Les couches d'oxyde utilisées pour un tel collage direct sont généralement obtenues par des dépôts de SiO₂ de type PECVD (dépôt chimique en phase vapeur assisté par plasma). Un des avantages de ces dépôts est qu'ils sont mis en oeuvre à une température relativement basse (par exemple environ 380°C), ce qui permet de ne pas endommager des composants, ou des dépôts d'autres matériaux, réalisés à la surface des éléments à solidariser, en particulier en évitant d'induire des contraintes liées aux différences de coefficients de dilatation thermique des matériaux présents sur ou dans ces éléments.

Un problème couramment rencontré lorsque l'on souhaite réaliser un tel collage direct est que l'énergie de collage, obtenue grâce aux forces attractives d'interaction électronique entre les atomes ou molécules des deux surfaces à coller et correspondant à la somme des énergies de surface de chacune des deux surfaces, est insuffisante pour l'application envisagée (par exemple, cette énergie de collage peut être inférieure à 2 J/m² après un traitement thermique à 200°C pendant 2 heures), et ce malgré une planarisation préalable des surfaces. En effet, si on compare les énergies de collage obtenues avec des oxydes thermiques nettoyés, collés et traités thermiquement pendant 2 heures à 200°C, et les énergies de collage obtenues avec des oxydes thermiques planarisés, collés et traités thermiquement pendant 2 heures à 200°C, ces dernières peuvent être trois à quatre fois plus importantes (typiquement égales à environ 2 J/m², comparé à environ 0,6 J/m² sans planarisation).

La valeur de l'énergie de collage entre deux substrats et celle de l'énergie de surface qu'on en déduit peuvent être déterminées, après un traitement thermique préalable à environ 200°C pendant environ 2 heures, en insérant une lame d'épaisseur égale à environ 600 µm entre les deux substrats collés (suivant la technique dite de Maszara) au niveau de leur chanfrein, dans une ambiance de salle blanche, avec un taux d'humidité de l'ordre de 40 % et à une température ambiante de l'ordre de 20°C.

Le procédé de planarisation (également appelé procédé de polissage mécano-chimique ou procédé de planarisation mécano-chimique, ou encore CMP) est un procédé de lissage réalisant en même temps une activation de surface. Une CMP consiste typiquement à lisser les surfaces (par exemple composées d'oxyde) par frottement de ces surfaces avec un « tissu » de polissage en présence d'un liquide, appelé « slurry », chargé d'abrasifs, pendant une durée par exemple comprise entre environ 10 secondes et 1 minute. Les vitesses d'abrasion typiques pour des couches de SiO₂ déposées par PECVD sont de l'ordre de 0,2 à 0,3 µm/mn. Une telle planarisation permet de laisser en surface des couches des liaisons chimiques favorables pour un collage direct ultérieur entre ces couches.

Toutefois, pour la plupart des oxydes déposés, dont l'épaisseur est par exemple de l'ordre d'environ 1 µm, planarisés (lissés) et destinés à être collés par adhérence moléculaire, une CMP ne permet pas d'obtenir des énergies de collage supérieures à environ 2 J/m², c'est-à-dire une énergie de surface égale à environ 1 J/m², alors que la structure empilée a été soumise à un traitement thermique de 2 heures à environ 200°C. Or, pour certaines applications, il peut être nécessaire d'obtenir une énergie de collage plus importante.

Diverses approches ont été tentées pour augmenter l'énergie de collage, parmi lesquelles on peut citer des traitements de surface par plasma (par exemple sous oxygène ou sous azote). Les énergies de collage obtenues pour des collages de deux surfaces d'oxyde, par exemple d'épaisseur égale à environ 1 µm, après des traitements thermiques d'environ 2 heures à 200 °C, ne sont guère supérieures à environ 2 J/m².

US2004/0126993 divulgue un procédé de collage de deux couches dans lequel des liaisons silanoles sont crées en surface des couches.

### EXPOSÉ DE L'INVENTION

Un but de la présente invention est de proposer un procédé permettant d'augmenter l'énergie de surface d'au moins une première couche de matériau, par exemple à base d'oxyde de silicium, et destinée à être solidarisée à une deuxième couche matériau par un collage direct, et donc d'augmenter l'énergie de collage entre les surfaces de ces deux couches de matériau lorsqu'elles sont solidarisées ultérieurement l'une à l'autre par collage direct.

Pour cela, la présente invention propose un procédé de traitement d'au moins une première couche de matériau comportant des liaisons siloxanes dont au moins une surface est destinée à être solidarisée à une surface d'une deuxième couche matériau par un collage direct, comportant au moins une étape de diffusion forcée, au moins dans la première couche de matériau, d'espèces chimiques comprenant au moins une paire d'électrons libres et au moins un proton labile, transformant au moins une partie des liaisons siloxanes en liaison silanoles dans au moins une partie de la première couche de matériau s'étendant depuis ladite surface jusqu'à une profondeur supérieure ou égale à environ 10 nm.

Les espèces chimiques comprenant une paire d'électrons libres sont également appelées « base de Lewis ». Les espèces chimiques comprenant au moins un proton labile sont également appelées « acide de Brönsted », et concerne toute espèce chimique qui peut libérer un ou plusieurs protons lors d'une réaction acide-base. Une espèce chimique comporte un proton labile lorsqu'elle présente un caractère acide, c'est-à-dire qu'un pKa existe pour cette espèce. Toutes les espèces dont le pKa est par exemple compris entre 1 et 14 comportent donc au moins un proton labile.

L'expressions « diffusion forcée » signifie que les espèces chimiques pénètrent dans le matériau et interagissent avec ce matériau au niveau de la surface de celui-ci (surface destinée à être collée à la deuxième couche de matériau) ainsi que dans une partie du volume de la couche se trouvant sous cette surface jusqu'à une profondeur d'au moins 10 nm sous cette surface (ou une profondeur d'au moins 20 nm ou 50 nm), et ce sans dégrader l'état de surface du matériau par exemple par gravure. Cette diffusion forcée peut être obtenue à une température supérieure à la température ambiante, par exemple supérieure à environ 30°C, pendant une durée d'autant plus longue que la température est basse. Cette diffusion forcée des molécules n'est pas obtenue à l'aide d'un simple rinçage, par exemple à l'eau, car la température de l'eau et le temps de rinçage sont insuffisants pour permettre de modifier le matériau en profondeur (sur au moins 10 nm sous la surface à solidariser). Cette diffusion forcée peut être mise en oeuvre à une température supérieure ou égale à environ 30°C et/ou à une pression supérieure à la pression atmosphérique.

Préférentiellement, pour favoriser le mécanisme de transformation des liaisons siloxanes en liaisons silanoles, les espèces chimiques diffusées peuvent être choisies telles que la distance entre la base et l'acide de l'espèce chimique (correspondant par exemple à la distance O-H pour l'eau) soit de l'ordre grandeur d'une liaison Si-O, c'est-à-dire par exemple comprise entre environ 0,1 nm et 0,6 nm. Par exemple, les molécules d'eau vérifient ce critère, avec une distance base-acide égale à 0,16 nm.

Ce procédé permet d'obtenir rapidement (par exemple en moins de 24 heures) une énergie de surface supérieure à environ 1 J/m², voir même supérieure ou égale à environ 1,3 J/m², ce qui se traduit par une énergie de collage supérieure à environ 2 J/m² ou supérieure ou égale à environ 2,5 J/m² lorsque la première couche est solidarisée à la deuxième couche par collage direct et après un traitement thermique à environ 200°C pendant environ 2 heures.

Ce procédé est avantageusement mis en oeuvre pour une première couche composée de SiOₓ (avec x tel que 1 < x < 3) déposé par PECVD à partir de précurseurs de type TEOS (Tétraethoxysilane) et d'oxygène, une telle première couche comportant une tendance à se charger en eau après le dépôt.

La première couche peut être composée d'oxyde de silicium de formule SiO₂. Le procédé selon l'invention concerne également des couches composées d'oxyde de silicium de composition non stoechiométrique de formule SiOₓ avec 1 < x < 3 et avantageusement 1,5 < x < 2,5, et plus généralement les oxydes de formule générale SiOₓN_{y}C_{z} (avec x non nul, y et z pouvant eux être nuls), le quartz, la silice, le verre, tous ces matériaux pouvant éventuellement être dopés par exemple avec du phosphore, du bore ou du potassium.

L'invention concerne ainsi tous les matériaux comportant des liaisons siloxanes (liaisons entre atomes de silicium et atomes d'oxygène, du type Si-O-Si).

Les collages directs mettant en oeuvre de tels matériaux sont des collages hydrophiles car ils concernent l'adhérence de surfaces hydrophiles, c'est-à-dire de surfaces ayant une capacité à se lier avec de l'eau (par un mécanisme d'adsorption).

Les liaisons silanoles correspondent à des liaisons de formule Si-OH.

L'étape de diffusion forcée peut comporter une immersion de la première couche de matériau dans un liquide comportant les espèces chimiques.

Le liquide peut être de l'eau et être chauffé à une température supérieure ou égale à environ 30°C. A une température d'environ 30°C, la durée du traitement peut être supérieure à environ 24 heures pour permettre de transformer les liaisons siloxanes en liaisons silanoles sur une profondeur d'au moins 10 nm sous la surface de la couche. Plus la température du liquide sera élevée, plus la durée du traitement réalisant la diffusion forcée sera réduite. Par exemple, à une température égale à environ 50°C, environ 12 heures peuvent suffire pour réaliser cette transformation de liaisons chimiques au sein de la couche. Le chauffage du liquide permet d'accélérer la diffusion des espèces chimiques du liquide dans la couche subissant le traitement.

De manière avantageuse, lors de l'immersion de la première couche de matériau dans le liquide, le liquide peut être de l'eau et être chauffé à une température supérieure ou égale à environ 70°C, la première couche de matériau pouvant être immergée dans le liquide pendant une durée supérieure ou égale à environ 1 heure. On obtient ainsi rapidement, dans la première couche, une énergie de surface supérieure à environ 1 J/m², cette énergie pouvant atteindre, par exemple au bout 10 heures de traitement, une valeur supérieure à environ 1,2 J/m².

En variante, l'étape de diffusion forcée peut comporter une exposition de la première couche de matériau à une atmosphère comportant les espèces chimiques sous forme gazeuse, par exemple à une température supérieure à la température ambiante, ou par exemple supérieure à environ 50°C.

L'atmosphère peut être riche en eau et comporter par exemple un taux d'humidité supérieur ou égal à environ 70 %. L'exposition peut être réalisée à une température supérieure à environ 50°C.

L'étape de diffusion forcée peut être mise en oeuvre à une pression supérieure à la pression atmosphérique.

L'étape de diffusion forcée peut comporter une immersion de la première couche de matériau dans un liquide comportant les espèces chimiques et chauffé à une température supérieure à environ 100°C.

De manière générale, l'étape de diffusion forcée peut être mise en oeuvre à une température supérieure ou égale à environ 30°C.

Les espèces chimiques diffusées peuvent par exemple comporter des molécules de type H₂O et/ou N₂H₄ (hydrazine) et/ou NH₄OH (ammoniaque). Ces espèces chimiques permettent de transformer les liaisons siloxanes en liaisons silanoles. D'autres espèces chimiques peuvent être utilisées pour transformer les liaisons siloxanes en liaisons silanoles.

Le matériau de la première couche peut être un oxyde obtenu par la mise en oeuvre d'un dépôt sur un substrat composé de semi-conducteur ou d'une oxydation thermique dudit substrat.

L'invention concerne également un procédé de solidarisation d'au moins une première couche de matériau comportant des liaisons siloxanes contre au moins une deuxième couche de matériau, comportant au moins les étapes de :
- mise en oeuvre d'un procédé de traitement d'au moins la première couche de matériau tel que défini précédemment ;
- collage direct de la première couche de matériau contre la deuxième couche de matériau.

Le procédé de solidarisation peut comporter en outre une étape de planarisation mécano-chimique, par exemple une CMP, des surfaces de la première couche et de la deuxième couche de matériau destinées à être mises en contact l'une contre l'autre lors du collage direct, mise en oeuvre avant l'étape de collage direct. Cette planarisation peut être réalisée avant ou après l'étape de diffusion forcée.

Avantageusement, la deuxième couche de matériau peut également comporter des liaisons siloxanes et le procédé peut comporter en outre la mise en oeuvre d'un procédé de traitement de la deuxième couche de matériau tel que défini précédemment, dans des conditions identiques ou différentes (en termes d'espèces chimiques et/ou de température et/ou de durée) de celles du traitement appliqué à la première couche. Ainsi, les deux couches solidarisées l'une à l'autre par collage direct sont traitées au préalable par diffusion forcée d'espèces chimiques afin d'augmenter les énergies de surface des deux couches de matériau, ce qui augmente d'autant l'énergie de collage obtenue lors du collage direct de ces deux couches l'une contre l'autre.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 4 représentent les étapes d'un procédé de solidarisation par collage direct de deux couches de matériau, objet de la présente invention, selon un mode de réalisation particulier ;
- les figures 5 et 6 représentent des mesures d'énergies de surface obtenues par la mise en oeuvre d'un procédé de traitement, objet de la présente invention, selon différentes variantes ;
- la figure 7 représente des mesures de caractérisation de diffusion forcée d'eau dans une couche de matériau obtenue par la mise en oeuvre d'un procédé de traitement, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

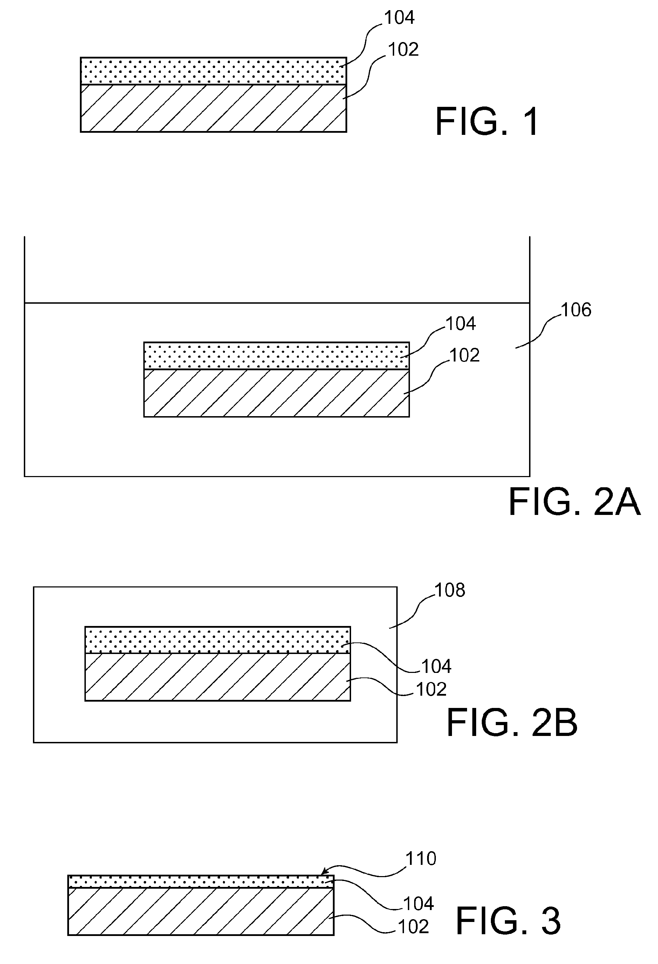

On se réfère aux figures 1 à 4 qui représentent les étapes d'un procédé de collage direct comportant la mise en oeuvre d'un procédé de traitement selon un mode de réalisation particulier, augmentant l'énergie de collage mise en jeu lors de ce collage.

Dans le procédé décrit ici, on réalise la solidarisation d'un premier substrat de silicium 102 avec un deuxième substrat de silicium 114 via des couches d'oxyde, par exemple composées de SiOₓ, réalisées sur ces deux substrats 102, 114 et collées par adhérence moléculaire l'une contre l'autre.

Comme représenté sur la figure 1, une couche de SiOₓ 104 est réalisée, par exemple par PECVD, sur une face du substrat 102. Cette couche de SiOₓ 104 est destinée à se trouver en regard du deuxième substrat 114 lors du collage direct.

On met ensuite en oeuvre un traitement permettant d'augmenter l'énergie de surface que présentera la couche de SiOₓ 104 lors du collage direct. On réalise pour cela une diffusion forcée d'eau dans la couche de SiOₓ 104. Comme représenté sur la figure 2A, cette diffusion forcée est par exemple obtenue en immergeant la couche d'oxyde 104 (ainsi que le premier substrat 102) dans un bac d'eau 106 portée à une température supérieure à la température ambiante, par exemple supérieure ou égale à environ 30°C et avantageusement comprise entre environ 70°C et 90°C.

Lorsque l'on augmente l'énergie de surface de la couche de SiOₓ 104, cette énergie augmente jusqu'à atteindre une valeur haute, par exemple égale à environ 1,3 J/m² pour le SiOₓ de la couche 104. Cette valeur haute est fonction des paramètres de dépôt et/ou de la nature du matériau de la couche 104, et/ou de l'épaisseur de la couche 104 lorsque cette épaisseur est inférieure à environ 0,5 µm. Pour une énergie de surface de la couche 104 de valeur donnée, la durée d'immersion de la couche 104 dans l'eau nécessaire pour atteindre cette valeur d'énergie de surface est d'autant plus longue que la température de l'eau est basse. Ainsi, une immersion de la couche d'oxyde 104 dans une eau chauffée à environ 90°C pendant environ 7 heures permet d'obtenir une même énergie de surface de la couche 104 qu'une immersion de la couche 104 dans une eau chauffée à environ 70°C pendant environ 10 heures.

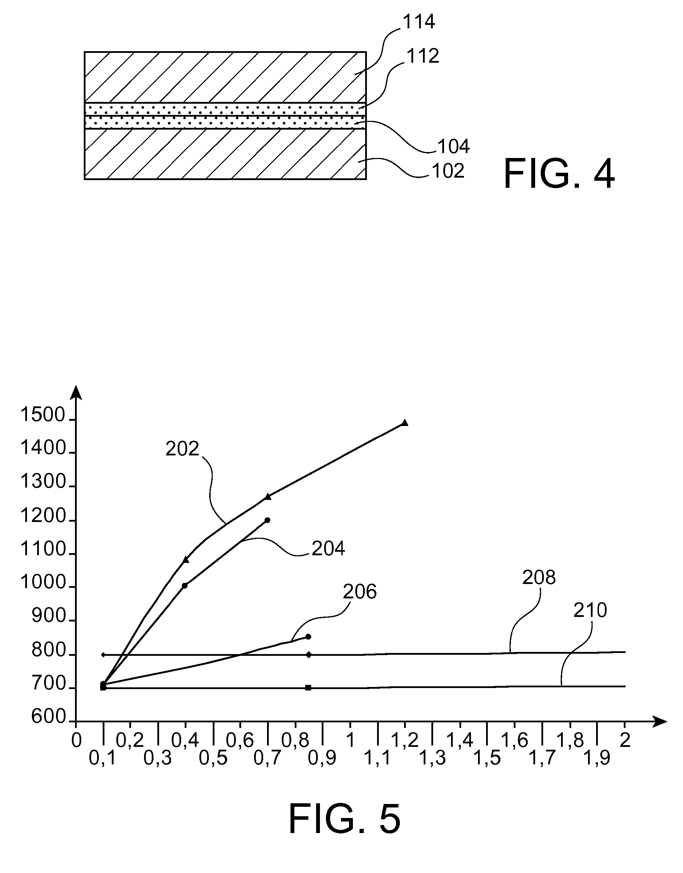

A titre d'illustration, les courbes représentées sur la figure 5 correspondent aux valeurs d'énergies de surface (en mJ/m² sur l'axe des ordonnées) obtenues dans la couche 104 pour des immersions dans une eau chauffée à différentes températures, en fonction de la durée d'immersion (indiquée en nombre de jours sur l'axe des abscisses).

Ainsi, la courbe 202 représente l'énergie de surface obtenue dans la couche 104, en fonction de la durée d'immersion de cette couche 104, dans une eau chauffée à environ 90°C. La courbe 204 représente l'énergie de surface obtenue pour une immersion de la couche 104 dans une eau chauffée à environ 70°C. On constate que l'effet d'augmentation d'énergie est d'autant plus rapide que la température est élevée tant qu'une certaine « saturation » du matériau n'est pas atteinte. Ainsi, à environ 0,4 jour, l'écart entre les courbes 202 et 204 est plus important qu'à environ 0,7 jour. A titre de comparaison, la courbe 206 représente l'énergie de surface obtenue pour une immersion de la couche 104 dans une eau à environ 20°C. Enfin, les courbes 208 et 210 représentent respectivement les valeurs hautes et basses de l'énergie de surface de la couche d'oxyde 104 lorsque celle-ci est laissée à l'air ambiant pendant une durée équivalente.

On voit donc sur ces courbes que le traitement par diffusion forcée d'eau dans la couche d'oxyde 104 permet d'augmenter rapidement la valeur de l'énergie de surface de la couche traitée. Dès 5 heures d'immersion dans une eau chauffée à environ 90°C (ou 9 heures dans une eau chauffée à environ 70°C), la couche 104 présente déjà une énergie de surface supérieure à environ 1 J/m². En immergeant la couche 104 dans une eau à 20°C, une telle énergie de surface de 1 J/m² ne pourrait être atteinte qu'au bout de 2 jours, ce qui n'est pas compatible pour un procédé destiné à être mis en oeuvre industriellement. En immergeant la couche 104 dans une eau chauffée à environ 50°C, une énergie de surface supérieure à environ 1 J/m² peut être atteinte en moins d'une journée (par exemple environ 18 heures).

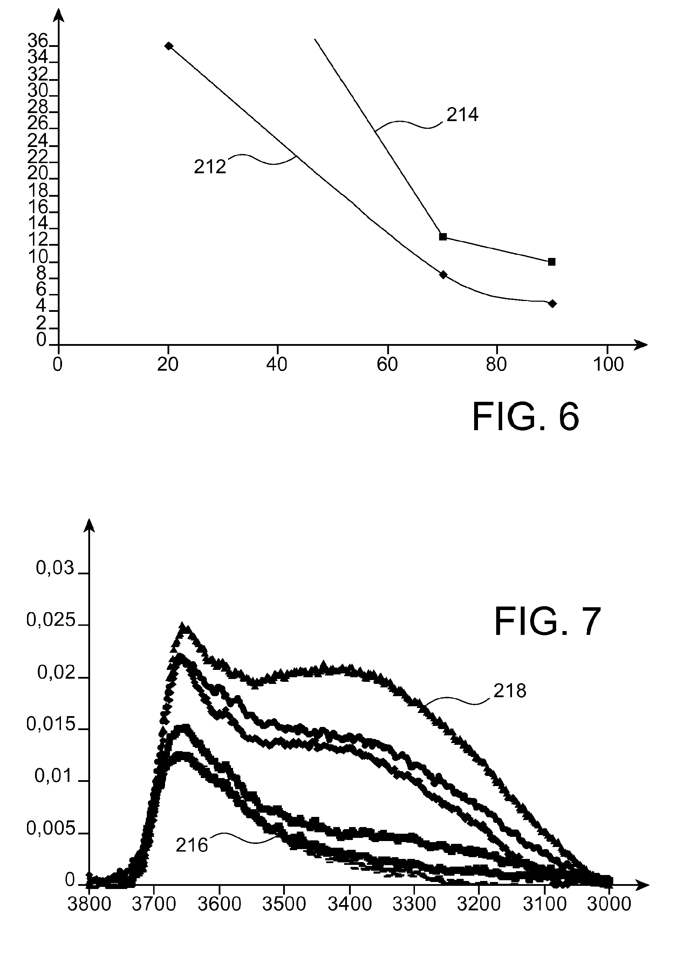

Une immersion dans une eau chauffée à environ 70°C pendant moins de 24 heures, par exemple environ 18 heures, permet d'obtenir une énergie de surface au moins égale à environ 1,2 J/m², c'est-à-dire une valeur proche de la valeur maximale pouvant être atteinte. Cette durée est réduite à environ 10 heures si la température de l'eau est de l'ordre de 90°C. Les courbes 212 et 214 illustrées sur la figure 6 représentent les durées d'immersion (en nombre d'heures sur l'axe des ordonnées) nécessaires pour obtenir une énergie de surface respectivement égale à 1 J/m² et 1,2 J/m² en fonction de la température de l'eau (en °C sur l'axe des abscisses) dans laquelle est immergée la couche d'oxyde 104.

En variante, la diffusion forcée d'eau dans l'oxyde de la couche 104 peut être obtenue en soumettant la couche d'oxyde 104 à une atmosphère présentant un taux d'humidité supérieur environ 70 % et à une température supérieure à environ 50°C, voire 70°C. Comme représenté sur la figure 2B, la couche d'oxyde 104 et le premier substrat 102 peuvent être disposés dans une enceinte fermée dans laquelle règne une telle atmosphère 108.

La diffusion forcée d'eau dans la couche d'oxyde 104, obtenue par immersion de la couche 104 dans de l'eau liquide ou en exposant la couche 104 à une atmosphère présentant un fort taux d'humidité, peut être réalisée avantageusement à une pression supérieure à la pression atmosphérique, par exemple comprise entre environ 1 et 100 bars. Comme la température de chauffe du liquide dans lequel est immergée la couche d'oxyde 104 ou encore le taux d'humidité auquel est exposée la couche d'oxyde 104, la pression est un paramètre permettant d'accélérer la diffusion d'espèces chimiques dans la couche 104. Enfin, cette pression supérieure à la pression atmosphérique permet également, dans une autre variante, de chauffer l'eau à une température supérieure à 100°C, ce qui réduit encore plus la durée du traitement pour augmenter l'énergie de surface de la couche d'oxyde 104.

De manière générale, les paramètres (température, durée, pression, etc.) de l'opération de diffusion forcée d'espèces chimiques dans un matériau sont adaptés en fonction de la nature du matériau subissant cette diffusion forcée et des techniques utilisées pour réaliser ce matériau pour obtenir l'énergie de collage souhaitée dans des conditions satisfaisantes pour l'application (notamment en termes de durée). Pour réduire la durée du traitement, on peut par exemple augmenter la température et/ou la pression. Des étapes de calibration du procédé pourront être effectuées par l'homme du métier pour déterminer les conditions optimales pour le matériau et l'application envisagée.

Comme représenté sur la figure 3, après avoir réalisé le traitement de diffusion forcée d'espèces chimiques dans la couche d'oxyde 104, on peut réaliser une planarisation mécano-chimique (CMP) de la couche 104, permettant de réduire la rugosité de la surface supérieure 110 (surface opposée à celle en contact avec le premier substrat 102) de la couche de SiOₓ 104 et ainsi la rendre si nécessaire compatible avec la mise en oeuvre d'un collage direct. Une rugosité inférieure ou égale à environ 1 nm RMS voire 0,6 nm RMS est avantageuse pour une surface d'oxyde de silicium afin de faciliter le collage. Cette étape de CMP augmente également l'énergie de surface de la couche d'oxyde 104, notamment au niveau de sa surface supérieure 110. Cette étape de CMP peut être réalisée de sorte à n'enlever qu'une épaisseur de matériau inférieure à celle dans laquelle l'opération de transformation de siloxanes en silanoles s'est opérée pour conserver au moins 5 nm, voire 10 nm ou plus, de cette épaisseur de matériau.

Dans une variante, il est possible de réaliser cette étape de planarisation avant la mise en oeuvre du traitement de diffusion forcée d'espèces chimiques dans la couche d'oxyde 104.

Une étape optionnelle de nettoyage peut également être réalisée à ce stade, juste avant la mise en contact des surfaces, pour éliminer notamment les hydrocarbures (par exemple par traitement de type CARO ou par traitement UV Ozone) ou pour éliminer d'éventuelles particules présentes sur la surface (par exemple par gravure SC1 dans un bain RCA NH₄OH . H₂O₂ : H20, typiquement dans des proportions [(0,1-1) : (1) : (1-100) ] .

Enfin, comme représenté sur la figure 4, on réalise ensuite un collage direct hydrophile par adhérence moléculaire entre la surface 110 de la couche de SiOₓ 104 et une surface d'une deuxième couche 112, par exemple composée de SiOₓ et solidarisée au deuxième substrat de silicium 114.

Un traitement thermique de renforcement du collage peut être réalisé pendant ou après l'étape de mise en contact. Dans les exemples décrits ici, un traitement à environ 200°C pendant environ 2 heures est réalisé. Mais il peut s'agir d'un traitement à plus haute température, par exemple supérieure ou égale à environ 500°C, voire supérieure ou égale à environ 800°C, suivant les applications et les énergies de collage recherchées.

Afin d'augmenter l'énergie de collage entre les deux couches 104 et 112, la deuxième couche d'oxyde 112 peut être également soumise à une diffusion forcée d'espèces chimiques réalisée par exemple de manière analogue à celle précédemment décrite pour la couche d'oxyde 104.

En variante, les deux couches 104 et 112 peuvent être traitées différemment. Par exemple, le collage d'une couche de SiOₓ trempée dans de l'eau à environ 90°C pendant environ 14 heures avec une couche d'oxyde thermique trempée dans de l'eau à environ 70°C pendant environ 7 heures permettra d'obtenir, après un traitement thermique à environ 200°C pendant 2 heures, une énergie de collage supérieure à 2,5 J/m².

En variante du procédé de traitement précédemment décrit, les molécules d'eau H₂O diffusées dans la couche 104 peuvent être remplacées par d'autres espèces chimiques, présentes dans un liquide dans le cas d'un traitement par immersion de la couche ou sous forme gazeuse dans le cas d'un traitement par exposition de la couche dans une atmosphère gazeuse, permettant d'augmenter également l'énergie de surface de la couche 104. De telles espèces chimiques correspondent à celles qui sont à la fois une base de Lewis (c'est-à-dire comportent au moins une paire d'électrons libres) et un acide de Brönsted (c'est-à-dire comportant au moins un proton labile). Ces espèces peuvent avantageusement être telles que la distance entre l'acide et la base de ces espèces chimiques est du même ordre de grandeur que celle d'une liaison Si - O, c'est-à-dire comprise entre environ 0,1 nm et 0,6 nm. Il est par exemple possible de diffuser des molécules d'hydrazine (N₂H₄) ou d'ammoniaque (NH₄OH) dans la couche 104 afin d'augmenter son énergie de surface.

Bien que le procédé de collage direct soit précédemment décrit pour un collage de couches déposées SiOₓ - SiOₓ, le traitement consistant à diffuser de manière forcée des molécules d'eau (ou d'autres espèces chimiques comme indiqué ci-dessus) dans une couche de matériau pour augmenter l'énergie de surface de celle-ci peut être réalisé également pour des oxydes thermiques, ou tout oxyde de silicium de formule général SiOₓN_{y}C_{z} (avec x non nul), du verre, de la silice, du quartz ou plus généralement tout matériau comportant des liaisons siloxanes (liaisons entre des atomes de silicium et des atomes d'oxygène, du type Si - O - Si).

Il est possible de caractériser la diffusion forcée d'eau obtenue en réalisant une caractérisation infrarouge de la couche traitée, par exemple par spectroscopie FTIR ATR, dans une gamme par exemple comprise entre environ 3000 et 3800 cm⁻¹ de la bande OH.

Les courbes 216 et 218 représentent l'absorbance (en unité arbitraire sur l'axe des ordonnées) de la couche d'oxyde 104 en fonction du nombre d'onde (en cm⁻¹ sur l'axe des abscisses) respectivement juste après le dépôt de l'oxyde et après une diffusion importante d'eau dans la couche 104.

Cette absorbance est représentative de la quantité de molécules OH dans la couche d'oxyde 104. Une énergie de surface de l'ordre de 0,6 J/m² est obtenue juste après le dépôt, et une énergie de surface de l'ordre de 1,25 J/m² est obtenue après diffusion d'eau dans la couche 104. Les autres courbes représentées sur la figure 7 correspondent à cette même absorbance mesurée au cours du traitement réalisé.

## Revendications

1. Procédé de traitement d'au moins une première couche de matériau (104) comportant des liaisons siloxanes dont au moins une surface (110) est destinée à être solidarisée à une surface d'une deuxième couche de matériau (112) par un collage direct, comportant au moins une étape de diffusion forcée, au moins dans la première couche de matériau (104), d'espèces chimiques comprenant au moins une paire d'électrons libres et au moins un proton labile, transformant au moins une partie des liaisons siloxanes en liaisons silanoles dans au moins une partie de la première couche de matériau (104) s'étendant depuis ladite surface (110) jusqu'à une profondeur supérieure ou égale à environ 10 nm.

2. Procédé de traitement selon la revendication 1, dans lequel les espèces chimiques diffusées comportent des molécules de type H₂O et/ou N₂H₄ et/ou NH₄OH.

3. Procédé de traitement selon l'une des revendications précédentes, dans lequel l'étape de diffusion forcée comporte une immersion de la première couche de matériau (104) dans un liquide (106) comportant les espèces chimiques.

4. Procédé de traitement selon la revendication 3, dans lequel le liquide (106) est de l'eau et est chauffé à une température supérieure ou égale à environ 30°C.

5. Procédé de traitement selon l'une des revendications 3 ou 4, dans lequel, lors de l'immersion de la première couche de matériau (104) dans le liquide (106), le liquide (106) est de l'eau et est chauffé à une température supérieure ou égale à environ 70°C, la première couche de matériau (104) étant immergée dans le liquide (106) pendant une durée supérieure ou égale à environ 1 heure.

6. Procédé de traitement selon l'une des revendications 1 ou 2, dans lequel l'étape de diffusion forcée comporte une exposition de la première couche de matériau (104) à une atmosphère (108) comportant les espèces chimiques sous forme gazeuse.

7. Procédé de traitement selon la revendication 6, dans lequel l'atmosphère (108) comporte un taux d'humidité supérieur ou égal à environ 70 % et l'exposition est réalisée à une température supérieure à environ 50°C.

8. Procédé de traitement selon l'une des revendications précédentes, dans lequel l'étape de diffusion forcée est mise en oeuvre à une pression supérieure à la pression atmosphérique.

9. Procédé de traitement selon la revendication 8, dans l'étape de diffusion forcée comporte une immersion de la première couche de matériau (104) dans un liquide (106) comportant les espèces chimiques et chauffé à une température supérieure à environ 100°C.

10. Procédé de traitement selon l'une des revendications précédentes, dans lequel le matériau de la première couche (104) est un oxyde de silicium obtenu par la mise en oeuvre d'un dépôt sur un substrat (102) composé de semi-conducteur ou d'une oxydation thermique dudit substrat (102).

11. Procédé de solidarisation d'au moins une première couche de matériau (104) comportant des liaisons siloxanes contre au moins une deuxième couche de matériau (112), comportant au moins les étapes de :
- mise en oeuvre d'un procédé de traitement d'au moins la première couche de matériau (104) selon l'une des revendications 1 à 10 ;
- collage direct de la première couche de matériau (104) contre la deuxième couche de matériau (112).

12. Procédé de solidarisation selon la revendication 11, comportant en outre une étape de planarisation mécano-chimique des surfaces de la première couche (104) et de la deuxième couche de matériau (112) destinées à être mises en contact l'une contre l'autre lors du collage direct, mise en oeuvre avant l'étape de collage direct.

13. Procédé de solidarisation selon l'une des revendications 11 ou 12, comportant en outre la mise en oeuvre d'un procédé de traitement de la deuxième couche de matériau (112) selon l'une des revendications 1 à 10.

## Patentansprüche

1. Verfahren zum Behandeln zumindest einer ersten Materialschicht (104), die Siloxanbindungen enthält, wovon zumindest eine Fläche (110) dazu bestimmt ist, durch direktes Bonden fest mit einer Fläche einer zweiten Materialschicht (112) verbunden zu werden, umfassend zumindest einen Schritt der Zwangsdiffusion von chemischen Spezies in der ersten Materialschicht (104), welche zumindest ein Paar von freien Elektronen und zumindest ein labiles Proton aufweisen, wodurch zumindest ein Teil der Siloxanbindungen in Silanolbindungen in zumindest einem Teil der ersten Materialschicht (104) umgewandelt werden, die sich von der Fläche (110) bis in eine Tiefe erstreckt, die größer oder gleich etwa 10 nm ist.

2. Verfahren zum Behandeln nach Anspruch 1, wobei die diffundierten chemischen Spezies Moleküle vom Typ H₂O und/oder N₂H₄ und/oder NH₄OH enthalten.

3. Verfahren zum Behandeln nach einem der vorangehenden Ansprüche, wobei der Schritt der Zwangsdiffusion ein Eintauchen der ersten Materialschicht (104) in eine Flüssigkeit (106) umfasst, welche die chemischen Spezies enthält.

4. Verfahren zum Behandeln nach Anspruch 3, wobei die Flüssigkeit (106) Wasser ist und auf eine Temperatur höher oder gleich etwa 30 °C erwärmt wird.

5. Verfahren zum Behandeln nach einem der Ansprüche 3 oder 4, wobei beim Eintauchen der ersten Materialschicht (104) in die Flüssigkeit (106) die Flüssigkeit (106) Wasser ist und auf eine Temperatur höher oder gleich etwa 70 °C erwärmt wird, wobei die erste Materialschicht (104) für eine Zeitdauer höher oder gleich etwa 1 Stunde in die Flüssigkeit (106) eingetaucht wird.

6. Verfahren zum Behandeln nach einem der Ansprüche 1 oder 2, wobei der Schritt der Zwangsdiffusion ein Aussetzen der ersten Materialschicht (104) einer Atmosphäre (108) umfasst, welche die chemischen Spezies in gasförmiger Form enthält.

7. Verfahren zum Behandeln nach einem Anspruch 6, wobei die Atmosphäre (108) einen Feuchtigkeitsgehalt höher oder gleich etwa 70 % aufweist und das Aussetzen bei einer Temperatur von über etwa 50 °C erfolgt.

8. Verfahren zum Behandeln nach einem der vorangehenden Ansprüche, wobei der Schritt der Zwangsdiffusion bei einem Druck höher als der Atmosphärendruck erfolgt.

9. Verfahren zum Behandeln nach Anspruch 8, wobei der Schritt der Zwangsdiffusion ein Eintauchen der ersten Materialschicht (104) in eine Flüssigkeit (106) umfasst, welche die chemischen Spezies enthält und auf eine Temperatur höher als etwa 100 °C erwärmt wird.

10. Verfahren zum Behandeln nach einem der vorangehenden Ansprüche, wobei das Material der ersten Schicht (104) Siliziumoxid ist, das mittels Durchführen einer Abscheidung auf ein aus Halbleiter bestehendes Substrat (102) oder einer thermischen Oxidation des Substrats (102) gewonnen wird.

11. Verfahren zum festen Verbinden zumindest einer ersten Materialschicht (104), die Siloxanbindungen enthält, mit zumindest einer zweiten Materialschicht (112), umfassend zumindest die nachfolgenden Schritte:
- Durchführen eines Verfahrens zum Behandeln von zumindest der ersten Materialschicht (104) nach einem der Ansprüche 1 bis 10;
- direktes Bonden der ersten Materialschicht (104) auf die zweite Materialschicht (112).

12. Verfahren zum festen Verbinden nach Anspruch 11, ferner umfassend einen Schritt des chemisch-mechanischen Polierens der Flächen der ersten Schicht (104) und der zweiten Materialschicht (112), die dazu bestimmt sind, beim direkten Bonden miteinander in Kontakt gebracht zu werden, welcher vor dem Schritt des direkten Bondens erfolgt.

13. Verfahren zum festen Verbinden nach einem der Ansprüche 11 oder 12, ferner umfassend das Durchführen eines Verfahrens zum Behandeln der zweiten Materialschicht (112) nach einem der Ansprüche 1 bis 10.

## Claims

1. Method for treating at least one first material layer (104) comprising siloxane bonds wherein at least one surface (110) is intended to be interlocked with a surface of a second material layer (112) by direct bonding, comprising at least one forced diffusion step, at least in the first material layer (104), of chemical species comprising at least one pair of free electrons and at least one labile proton, converting at least one portion of the siloxane bonds into silanol bonds in at least one portion of the first material layer (104) extending from said surface (110) to a depth greater than or equal to approximately 10 nm.

2. Method according to claim 1, wherein the diffused chemical species comprise H₂O and/or N₂H₄ and/or NH₄OH type molecules.

3. Method according to any of the previous claims, wherein the forced diffusion step comprises dipping of the first material layer (104) in a liquid (106) comprising the chemical species.

4. Method according to claim 3, wherein the liquid (106) is water and is heated to a temperature greater than or equal to approximately 30°C.

5. Method according to any of claims 3 or 4, wherein, when dipping the first material layer (104) in the liquid (106), the liquid (106) is water and is heated to a temperature greater than or equal to approximately 70°C, the first material layer (104) being dipped in the liquid (106) for a time greater than or equal to approximately 1 hour.

6. Method according to any of claims 1 or 2, wherein the forced diffusion step comprises exposure of the first material layer (104) to an atmosphere (108) comprising the chemical species in gaseous form.

7. Method according to claim 6, wherein the atmosphere (108) comprises a humidity level greater than or equal to approximately 70% and the exposure is carried out at a temperature greater than approximately 50°C.

8. Method according to any of the previous claims, wherein the forced diffusion step is implemented at a pressure greater than atmospheric pressure.

9. Method according to claim 8, wherein the forced diffusion step comprises dipping of the first material layer (104) in a liquid (106) comprising the chemical species and heated to a temperature greater than approximately 100°C.

10. Method according to any of the previous claims, wherein the material of the first layer (104) is a silicon oxide obtained using a deposition on a substrate (102) comprising semiconductor or a thermal oxidation of said substrate (102).

11. Method for interlocking at least one first material layer (104) comprising siloxane bonds against at least one second material layer (112), comprising at least steps for:
- using a method for treating said at least one first material layer (104) according to any of claims 1 to 10;
- direct bonding of the first material layer (104) against the second material layer (112).

12. Method according to claim 11, further comprising a chemical-mechanical planarisation step of the surfaces of the first (104) and second material layer (112) intended to be placed in contact against each other during the direct bonding, carried out before the direct bonding step.

13. Method according to any of claims 11 or 12, further comprising the use of a method for treating the second material layer (112) according to any of claims 1 to 10.
